# EUROPEAN PATENT APPLICATION

(11) **EP 4 495 993 A1**
(43) Date of publication of application: **22.01.2025**
(21) Application number: 23829387.2
(22) Date of filing: 06.02.2023
(51) Int. Cl.: H01L 23/473

(54) **CHIP LIQUID-COOLING HEAT DISSIPATION STRUCTURE AND FABRICATION METHOD THEREFOR, AND ELECTRONIC DEVICE**

(30) Priority: 27.06.2022 CN 202210736620
(71) Applicant: ZTE Corporation, Shenzhen, Guangdong 518057 (CN)
(72) Inventor: TAO, Cheng, Shenzhen, Guangdong 518057 (CN); LIU, Fan, Shenzhen, Guangdong 518057 (CN); ZHOU, Xiaodong, Shenzhen, Guangdong 518057 (CN)
(74) Representative: WBH Wachenhausen Patentanwälte PartG mbB
(86) International application number: PCT/CN2023/074666
(87) International publication number: WO 2024/001194

(57) **Abstract**

The present application discloses a chip liquid-cooling heat dissipation structure and a fabrication method therefor, and an electronic device. The chip liquid-cooling heat dissipation structure comprises a bare chip (100) and a cover plate (200). The bare chip (100) is provided with a chip body (120), and a plurality of micro-channels (121) are etched on the surface of the chip body (120). The cover plate (200) is used for sealing the micro-channels (121), the cover plate (200) is detachably connected to the bare chip (100), the cover plate (200) is provided with a water inlet (210) and a water outlet (220), and the micro-channels (121) are separately in communication with the water inlet (210) and the water outlet (220).

## Description

### CROSS-REFERENCE TO RELATED APPLICATION

This application is filed on the basis of Chinese Patent Application No. 202210736620.6 filed on June 27, 2022, and claims priority to the Chinese patent application, the entire contents of which are incorporated herein by reference.

### TECHNICAL FIELD

Embodiments of this application relate to the technical field of semiconductors, and in particular, to a chip liquid-cooling heat-dissipation structure, a manufacturing method therefor, and an electronic device.

### BACKGROUND

As development of chips follows Moore's law, power density is gradually increasing, and some industries, such as gallium nitride power devices, have exceeded 1000 W/cm². Therefore, conventional air cooling and liquid cooling can no longer meet heat dissipation requirements of chips.

At present, the conventional heat dissipation methods including both air cooling and liquid cooling involve removing heat from a chip with a conventional-sized heat sink. With the increase of heat density, the proportion of interface thermal resistance is increasing, and the convective heat transfer capability is approaching its limit, resulting in insufficient heat dissipation capability. In the related art, a chip is designed to be integrated with a heat sink in the field of gallium nitride devices. However, the integrated design has unsatisfactory reliability and is difficult to maintain. Once a heat dissipation channel is blocked or other reliability problem occurs, the entire chip cannot be used.

### SUMMARY

The following is a summary of a subject matter described in detail herein. This summary is not intended to limit the protection scope of the claims.

Embodiments of the present disclosure provide a chip liquid-cooling heat-dissipation structure, a manufacturing method therefor, and an electronic device.

According to a first aspect of the present disclosure, an embodiment provides a chip liquid-cooling heat-dissipation structure, including: a bare chip, provided with a body, a plurality of microchannels being etched on a surface of the body; and a cover plate, configured to cover the microchannels, where the cover plate is detachably connected to the bare chip, the cover plate is provided with an inlet and an outlet, and the microchannels are communicated with the inlet and the outlet.

According to a second aspect of the present disclosure, an embodiment provides an electronic device, including the chip liquid-cooling heat-dissipation structure described in the first aspect.

According to a third aspect of the present disclosure, an embodiment provides a manufacturing method for a chip liquid-cooling heat-dissipation structure, including: etching a plurality of microchannels on a surface of a body of a bare chip; and installing a cover plate on the bare chip to cover the microchannels, where the cover plate is detachably connected to the bare chip, the cover plate is provided with an inlet and an outlet, and the microchannels are communicated with the inlet and the outlet.

Additional features and advantages of the present disclosure will be set forth in the description which follows, and in part will be apparent from the description, or may be learned by the practice of the present disclosure. The objectives and other advantages of the present disclosure can be realized and obtained by the structures particularly pointed out in the description, claims, and drawings.

### BRIEF DESCRIPTION OF DRAWINGS

The drawings are provided for a further understanding of the technical schemes of the present disclosure, and constitute a part of the description. The drawings and the embodiments of the present disclosure are used to illustrate the technical schemes of the present disclosure, but are not intended to limit the technical schemes of the present disclosure.
FIG. 1 is a schematic structural diagram of a bare chip;
FIG. 2 is a schematic diagram of a chip liquid-cooling heat-dissipation structure according to an embodiment of the present disclosure;
FIG. 3 is a schematic structural diagram of a bare chip according to an embodiment of the present disclosure;
FIG. 4 is a front structural diagram of a cover plate according to an embodiment of the present disclosure;
FIG. 5 is a back structural diagram of a cover plate according to an embodiment of the present disclosure;
FIG. 6 is a cross-sectional structural diagram of a bare chip according to an embodiment of the present disclosure;
FIG. 7 is a structural diagram of another cover plate according to an embodiment of the present disclosure;
FIG. 8 is a schematic structural diagram of a body according to an embodiment of the present disclosure;
FIG. 9 is a flowchart of a manufacturing method for a chip liquid-cooling heat-dissipation structure according to an embodiment of the present disclosure;
FIG. 10 is a sub-flowchart of a manufacturing method for a chip liquid-cooling heat-dissipation structure according to an embodiment of the present disclosure; and
FIG. 11 is another sub-flowchart of a manufacturing method for a chip liquid-cooling heat-dissipation structure according to an embodiment of the present disclosure.

### DETAILED DESCRIPTION

To make the objectives, technical schemes, and advantages of the present disclosure clear, the present disclosure is described in further detail in conjunction with accompanying drawings and embodiments. It should be understood that the specific embodiments described herein are merely used for illustrating the present disclosure, and are not intended to limit the present disclosure.

It should be understood that in the description of the embodiments of the present disclosure, the term "plurality of (or multiple)" means two or more, the terms such as "greater than", "less than", "exceed" prior to a number or series of numbers are understood to not include the number adjacent to the term. The terms such as "above", "below", "within" prior to a number or series of numbers are understood to include the number adjacent to the term. If used herein, the terms such as "first", "second", and the like are merely used for distinguishing technical features, and are not intended to indicate or imply relative importance, or implicitly point out the number of the indicated technical features, or implicitly point out the precedence order of the indicated technical features.

At present, the conventional heat dissipation methods including both air cooling and liquid cooling involve removing heat from a chip with a conventional-sized heat sink. With the increase of heat density, the proportion of interface thermal resistance is increasing, and the convective heat transfer capability is approaching its limit, resulting in insufficient heat dissipation capability. In the related art, a chip is designed to be integrated with a heat sink in the field of gallium nitride devices. However, the integrated design has unsatisfactory reliability and is difficult to maintain. Once a heat dissipation channel is blocked or other reliability problem occurs, the entire chip cannot be used.

In view of the foregoing problem, embodiments of the present disclosure provide a chip liquid-cooling heat-dissipation structure, a manufacturing method therefor, and an electronic device. The chip liquid-cooling heat-dissipation structure includes a bare chip and a cover plate. The bare chip is provided with a body, and a plurality of microchannels are etched on a surface of the body. The cover plate is configured to cover the microchannels. The cover plate is detachably connected to the bare chip, and is provided with an inlet and an outlet. The microchannels are communicated with the inlet and the outlet. Based on this, the microchannels are manufactured on the surface of the body, and the cover plate and the bare chip are designed to be detachable from each other, such that ultra-high heat dissipation capability can be ensured while realizing detachable maintenance of the chip microchannels, thereby improving product reliability and reusability, reducing costs, and ultimately improving product competitiveness.

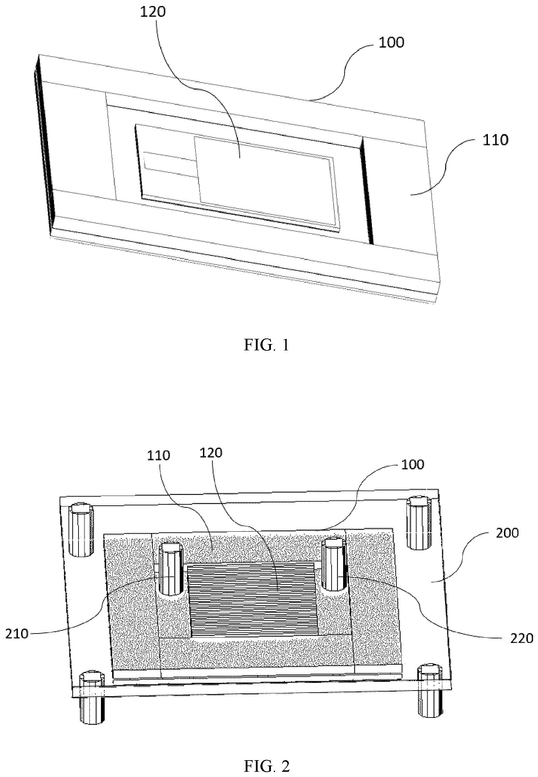

In the related art, as shown in FIG. 1, a bare chip 100 is surrounded by a chip protection enclosure 110, the chip protection enclosure 110 protects a body 120 of the chip located in the middle. A wiring area and a heat source are arranged at a bottom layer of the body 120, and a top portion of the body 120 is monocrystalline silicon. Conventional system-level heat dissipation uses a heat sink to dissipate heat for the bare chip, where a bottom surface of the heat sink has a long boss, and an interface material such as thermally conductive silicone is arranged between the heat sink and the bare chip, to achieve a heat dissipation capability.

As shown in FIG. 2 to FIG. 8, the chip liquid-cooling heat-dissipation structure of the present disclosure includes a bare chip 100 and a cover plate 200. The bare chip 100 is provided with a body 120, and a plurality of microchannels 121 are etched on a surface of the body 120. The cover plate 200 is configured to cover the microchannels 121. The cover plate 200 is detachably connected to the bare chip 100, and is provided with an inlet 210 and an outlet 220. The microchannels 121 are communicated with the inlet 210 and the outlet 220. Since heat emitted by a heat source at a bottom layer of the body 120 is transferred from bottom to top to the plurality of microchannels 121 on the upper surface of the body 120, a coolant entering from the inlet 210 of the cover plate 200, flowing through the plurality of microchannels 121 and then flowing out of the outlet 220 can remove the heat, achieving an efficient heat dissipation effect. Furthermore, the cover plate 200 and the bare chip 100 are designed to be detachable from each other, such that when a microchannel 121 is blocked, the cover plate 200 can be easily detached to clean the microchannel 121, thereby achieving detachable maintenance. It should be noted that the microchannels are heat dissipation channels with a width of 10 um to 100 um.

In an example implementation, taking a single board installed on a device as an example, a specific maintenance process is as follows. When it is detected that pressure of a microchannel 121 of the body 120 on the board is abnormal, that is, the microchannel 121 is blocked, the board is drawn out. Then, screws 250 are loosened, and the cover plate 200 and a rubber pad 300 are removed. The microchannel 121 is cleaned and dried, a new rubber pad 300 is prepared and installed, the cover plate 200 is installed, the screws 250 are tightened, and the board is reinserted into the device.

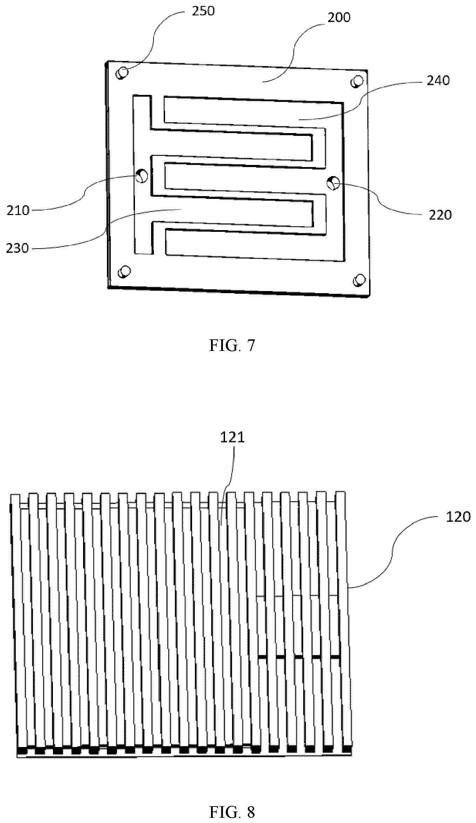

In an example implementation, as shown in FIG. 7, a diversion structure may be further arranged on a side of the cover plate 200 facing the microchannels 121. The diversion structure includes a liquid inlet manifold 230 connected to the inlet 210 and a liquid outlet manifold 240 connected to the outlet 220. The liquid inlet manifold 230 and the liquid outlet manifold 240 can enhance heat exchange and reduce flow resistance. In addition, the cover plate 200 may be changed into different structural forms according to use requirements. For example, the number of liquid inlet or outlet manifolds may be changed or another diversion form may be used.

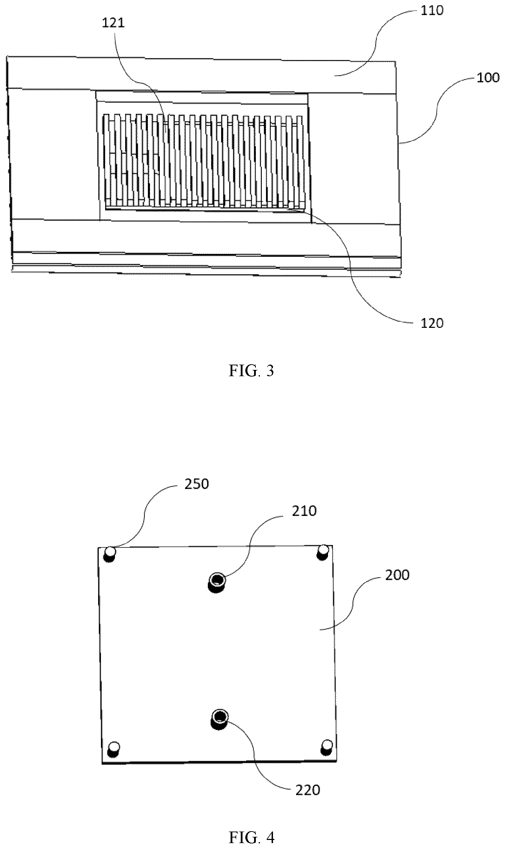

In an example implementation, as shown in FIG. 3, the bare chip 100 further includes a chip protection enclosure 110, and the body 120 is located inside the chip protection enclosure 110, which protects the body 120.

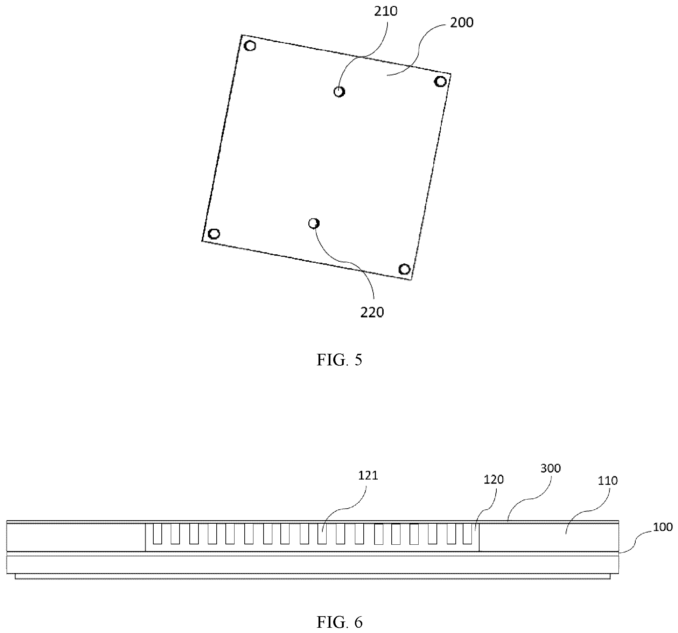

In an example implementation, as shown in FIG. 6, a rubber pad 300 is arranged between the cover plate 200 and the chip protection enclosure 110. The rubber pad 300 is attached to a surface of the chip protection enclosure 110, and the cover plate 200 is pressed on an upper portion of the rubber pad 300, and the cover plate 200 and the bare chip 100 can be combined by spring screws 250.

In an example implementation, as shown in FIG. 3, a spacing between a periphery surrounding the microchannels 121 and the chip protection enclosure 110 is less than 1 mm, to minimize a gap between the microchannels 121 on the body 120 and the chip protection enclosure 110, such that the coolant is restricted as much as possible to flow in the microchannels 121, to avoid ineffective flow of the coolant, thereby further improving the heat dissipation effect.

In an example implementation, as shown in FIG. 2 to FIG. 6, the cover plate 200 and the bare chip 100 may be connected by screws 250.

In an example implementation, as shown in FIG. 8, the microchannels 121 may be etched in monocrystalline silicon on an upper surface of the body 120, and a width of each of the microchannels 121 ranges from 10 um to 100 um. It should be noted that an arrangement manner of the microchannels 121 is not limited.

Based on this, in the present disclosure, the microchannels 121 are manufactured on the surface of the body 120, and the cover plate 200 and the bare chip 100 are designed to be detachable from each other, such that ultra-high heat dissipation capability can be ensured while realizing detachable maintenance of the chip microchannels 121, thereby improving product reliability and reusability, reducing costs, and ultimately improving product competitiveness.

It should be noted that instead of directly etching microchannels on the surface of the body, a base plate may be arranged on a top portion of the bare chip, and microchannels are etched on the base plate. The base plate may be combined with the bare chip by bonding, welding, or the like. Compared with the foregoing implementation of directly etching microchannels on the surface of the body, this implementation has little impact on chip design and high feasibility, but the heat dissipation capability may be reduced due to interface thermal resistance. It should be noted that, for a material of the base plate, a silicon plate with a satisfactory heat dissipation capability is preferentially selected, or a base plate containing a metal material may be selected, which is not limited in this implementation.

An embodiment of the present disclosure provides an electronic device. The electronic device includes the chip liquid-cooling heat-dissipation structure.

In an embodiment, since the electronic device uses the chip liquid-cooling heat-dissipation structure, the electronic device can achieve the same technical effects as the chip liquid-cooling heat-dissipation structure. The chip liquid-cooling heat-dissipation structure in the electronic device includes a bare chip 100 and a cover plate 200. The bare chip 100 is provided with a body 120, and a plurality of microchannels 121 are etched on a surface of the body 120. The cover plate 200 is configured to cover the microchannels 121. The cover plate 200 is detachably connected to the bare chip 100, and is provided with an inlet 210 and an outlet 220. The microchannels 121 are communicated with the inlet 210 and the outlet 220. Based on this, in the present disclosure, the microchannels 121 are manufactured on the surface of the body 120, and the cover plate 200 and the bare chip 100 are designed to be detachable from each other, such that ultra-high heat dissipation capability can be ensured while realizing detachable maintenance of the chip microchannels 121, thereby improving product reliability and reusability, reducing costs, and ultimately improving product competitiveness.

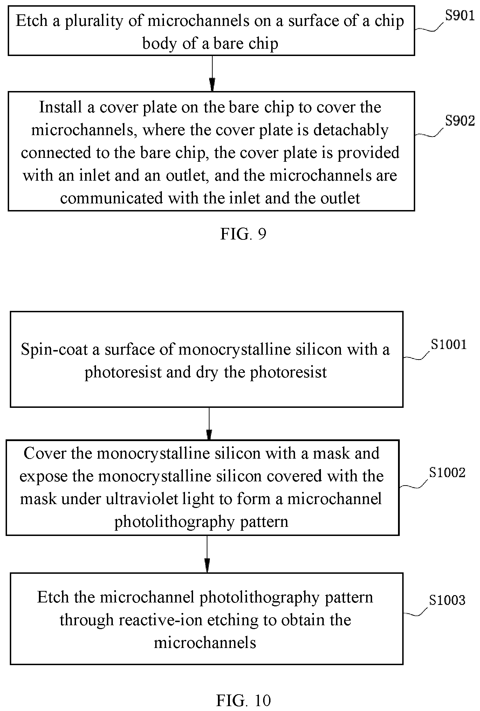

As shown in FIG. 9, an embodiment of the present disclosure provides a manufacturing method for a chip liquid-cooling heat-dissipation structure. The manufacturing method includes, but not limited to, the following steps.

In a step of S901, a plurality of microchannels are etched on a surface of a body of a bare chip.

In a step of S902, a cover plate is installed on the bare chip to cover the microchannels, where the cover plate is detachably connected to the bare chip, the cover plate is provided with an inlet and an outlet, and the microchannels are communicated with the inlet and the outlet.

The bare chip has a body. During manufacturing, the plurality of microchannels are etched on the surface of the body. For example, the microchannels may be etched through reactive-ion etching. The cover plate is installed on the bare chip. The cover plate is configured to cover the microchannels, is detachably connected to the bare chip, and is provided with the inlet and the outlet. The microchannels are communicated with the inlet and the outlet. Since heat emitted by a heat source at a bottom layer of the body is transferred from bottom to top to the plurality of microchannels on the upper surface of the body, a coolant entering from the inlet of the cover plate, flowing through the plurality of microchannels and then flowing out of the outlet can remove the heat, achieving an efficient heat dissipation effect. Furthermore, the cover plate and the bare chip are designed to be detachable from each other, such that when a microchannel is blocked, the cover plate can be easily detached to clean the microchannel, thereby achieving detachable maintenance.

In an example implementation, a width of the microchannel is 10 um to 100 um, and an arrangement manner of the plurality of microchannels is not limited.

As shown in FIG. 10, a top portion of the body is monocrystalline silicon, and step S901 may include, but not limited to, the following steps.

In a step of S1001, a surface of the monocrystalline silicon is spin-coated with a photoresist and dried.

In a step of S1002, the monocrystalline silicon is covered with a mask and exposed under ultraviolet light to form a microchannel photolithography pattern.

In a step of S1003, the microchannel photolithography pattern is etched through reactive-ion etching to obtain the microchannels.

In an example implementation, a surface of the monocrystalline silicon is spin-coated with a photoresist and dried, the monocrystalline silicon is covered with a mask and exposed under ultraviolet light to form a microchannel photolithography pattern, and the microchannel photolithography pattern is etched through reactive-ion etching to obtain the microchannels.

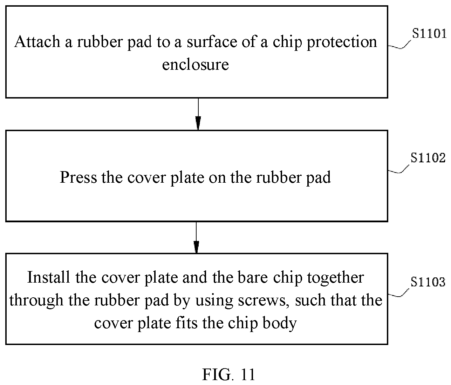

As shown in FIG. 11, the bare chip further includes a chip protection enclosure, and the body is located inside the chip protection enclosure. S902 may include, but not limited to, the following steps.

In a step of S1101, a rubber pad is attached to a surface of the chip protection enclosure.

In a step of S1102, the cover plate is pressed on the rubber pad.

In a step of S1103, the cover plate and the bare chip are installed together through the rubber pad by using screws, such that the cover plate fits the body.

In an example implementation, a rubber pad is attached to a surface of the chip protection enclosure, and the cover plate is pressed on an upper portion of the rubber pad, such that the cover plate and the bare chip can be combined by spring screws.

In an example implementation, a diversion structure may be further arranged on a side of the cover plate facing the microchannels. The diversion structure includes a liquid inlet manifold connected to the inlet and a liquid outlet manifold connected to the outlet. The liquid inlet manifold and the liquid outlet manifold can enhance heat exchange and reduce flow resistance. In addition, the cover plate may be changed into different structural forms according to use requirements. For example, the number of liquid inlet or outlet manifolds may be changed or another diversion form may be used.

In an example implementation, a spacing between a periphery surrounding the microchannels and the chip protection enclosure is less than 1 mm, to minimize a gap between the microchannels on the body and the chip protection enclosure, such that the coolant is restricted as much as possible to flow on the microchannel, to avoid ineffective flow of the coolant, thereby further improving the heat dissipation effect.

In an example implementation, taking a single board installed on a device as an example, a specific maintenance process is as follows. When it is detected that pressure of a microchannel of the body on the board is abnormal, that is, the microchannel is blocked, the board is drawn out. Then, the screws are loosened, and the cover plate and a rubber pad are removed. The microchannel is cleaned and dried, a new rubber pad is prepared and installed, the cover plate is installed, the screws are tightened, and the board is reinserted into the device.

Based on this, in the present disclosure, the microchannels are manufactured on the surface of the body, and the cover plate and the bare chip are designed to be detachable from each other, such that ultra-high heat dissipation capability can be ensured while realizing detachable maintenance of the chip microchannels, thereby improving product reliability and reusability, reducing costs, and ultimately improving product competitiveness.

The embodiments of the present disclosure include a chip liquid-cooling heat-dissipation structure, a manufacturing method therefor, an electronic device. The chip liquid-cooling heat-dissipation structure includes a bare chip and a cover plate. The bare chip is provided with a body, and a plurality of microchannels are etched on a surface of the body. The cover plate is configured to cover the microchannels. The cover plate is detachably connected to the bare chip, and is provided with an inlet and an outlet. The microchannels are communicated with the inlet and the outlet. Based on this, in the present disclosure, the microchannels are manufactured on the surface of the body, and the cover plate and the bare chip are designed to be detachable from each other, such that ultra-high heat dissipation capability can be ensured while realizing detachable maintenance of the chip microchannels, thereby improving product reliability and reusability, reducing costs, and ultimately improving product competitiveness.

Although some embodiments of the present disclosure have been described above, the present disclosure is not limited to the implementations described above. Those having ordinary skills in the art can make various equivalent modifications or replacements without departing from the essence of the present disclosure. Such equivalent modifications or replacements fall within the scope defined by the claims of the present disclosure.

## Claims

1. A chip liquid-cooling heat-dissipation structure, comprising:
a bare chip, provided with a body, wherein a plurality of microchannels are etched on a surface of the body; and
a cover plate, configured to cover the microchannels, wherein the cover plate is detachably connected to the bare chip, and is provided with an inlet and an outlet, and the microchannels are communicated with the inlet and the outlet.

2. The chip liquid-cooling heat-dissipation structure of claim 1, wherein a diversion structure is arranged on a side of the cover plate facing the microchannels, the diversion structure comprises a liquid inlet manifold connected to the inlet and a liquid outlet manifold connected to the outlet.

3. The chip liquid-cooling heat-dissipation structure of claim 1, wherein the bare chip further comprises a chip protection enclosure, and the body is located inside the chip protection enclosure.

4. The chip liquid-cooling heat-dissipation structure of claim 3, wherein a rubber pad is arranged between the cover plate and the chip protection enclosure.

5. The chip liquid-cooling heat-dissipation structure of claim 4, wherein a spacing between a periphery surrounding the microchannels and the chip protection enclosure is less than 1 mm.

6. The chip liquid-cooling heat-dissipation structure of claim 1, wherein the cover plate is connected to the bare chip by screws.

7. The chip liquid-cooling heat-dissipation structure of any one of claims 1 to 6, wherein a width of each of the microchannels ranges from 10 um to 100 um.

8. An electronic device, comprising the chip liquid-cooling heat-dissipation structure of any one of claims 1 to 7.

9. A manufacturing method for a chip liquid-cooling heat-dissipation structure, comprising:
etching a plurality of microchannels on a surface of a body of a bare chip; and
installing a cover plate on the bare chip to cover the microchannels, wherein the cover plate is detachably connected to the bare chip, and is provided with an inlet and an outlet, and the microchannels are communicated with the inlet and the outlet.

10. The manufacturing method of claim 9, wherein a top portion of the body is monocrystalline silicon; and
etching a plurality of microchannels on a surface of a body of a bare chip comprises:
spin-coating a surface of the monocrystalline silicon with a photoresist and drying the photoresist;
covering the monocrystalline silicon with a mask and exposing the monocrystalline silicon covered with the mask under ultraviolet light to form a microchannel photolithography pattern; and
etching the microchannel photolithography pattern through reactive-ion etching to obtain the microchannels.

11. The manufacturing method of claim 9, wherein the bare chip further comprises a chip protection enclosure, and the body is located inside the chip protection enclosure; and
installing a cover plate on the bare chip comprises:
attaching a rubber pad to a surface of the chip protection enclosure;
pressing the cover plate on the rubber pad; and
installing the cover plate and the bare chip together through the rubber pad by using screws, such that the cover plate fits the body.
